# EUROPEAN PATENT APPLICATION

(11) **EP 2 733 750 A1**
(43) Date of publication of application: **21.05.2014**
(21) Application number: 12814347.6
(22) Date of filing: 12.07.2012
(51) Int. Cl.: H01L 33/10

(54) **SEMICONDUCTOR LIGHT EMITTING ELEMENT**

(30) Priority: 15.07.2011 JP 2011156415
(71) Applicant: Panasonic Corporation, Osaka 571-8501 (JP)
(72) Inventor: NAKAMURA, Akiko, Osaka 540-6207 (JP); KUME, Masahiro, Osaka 540-6207 (JP); HIROKI, Masanori, Osaka 540-6207 (JP)
(74) Representative: Grünecker, Kinkeldey, Stockmair & Schwanhäusser
(86) International application number: PCT/JP2012/004523
(87) International publication number: WO 2013/011674

(57) **Abstract**

A semiconductor light emitting element of the present invention includes: a light-transmitting substrate; a semiconductor layer including an N-type semiconductor layer, a light-emitting layer, and a P-type semiconductor layer which are stacked on the substrate; a transparent conductive layer provided on the semiconductor layer; a multilayer reflective layer stacked on a reflective region of an upper surface of the transparent conductive layer which is divided into the reflective region as a region where light from the light-emitting layer is reflected and a conductive region as a region other than the reflective region; and a metal reflective layer provided so as to cover the conductive region and the multilayer reflective layer, wherein the multilayer reflective layer is formed by alternately stacking at least one first refractive index transparent layer having a refractive index of n1 and at least one second refractive index transparent layer having a refractive index of n2 lower than n1, and an outermost layer on the metal reflective layer side of the multilayer reflective layer is the second refractive index transparent layer.

## Description

### TECHNICAL FIELD

The present invention relates to semiconductor light emitting elements in which a semiconductor layer including a light-emitting layer is stacked on a substrate, and which includes a metal reflective layer that reflects light from the light-emitting layer toward the substrate.

### BACKGROUND ART

For example, the semiconductor light emitting elements disclosed in Patent Documents 1 and 2 are known as conventional semiconductor light emitting elements to be flip-chip mounted on a mount substrate.

Patent Document 1 describes a semiconductor light emitting element in which an anode electrode is formed on a P-type semiconductor layer by a first transparent conductive film, a second transparent conductive film, a plurality of multilayer reflective film layers that reflect light emitted from a light-emitting layer, a metal reflective film formed so as to cover both a part that is not covered by the multilayer reflective film layers and the multilayer reflective film layers and having high reflectance, a barrier metal film, and an external connection metal film comprised of a metal material.

Patent Document 2 describes a semiconductor light emitting element including between a P-type nitride semiconductor layer and an anode electrode a transparent conductive film having a lower refractive index than the P-type nitride semiconductor layer, low refractive index transparent films stacked partially on the transparent conductive film and having a low refractive index, and a reflective conductive film comprised of an Ag film that reflects light.

As described above, in Patent Documents 1 and 2, the multilayer reflective film layers that reflect light from the light-emitting layer by two kinds of dielectric films having different refractive indices, and the low refractive index transparent films are provided between the transparent conductive film and the metal reflective film (the reflective conductive film).

### CITATION LIST

### PATENT DOCUMENT

PATENT DOCUMENT 1: Japanese Unexamined Patent Publication No. 2007-258276
PATENT DOCUMENT 2: Japanese Unexamined Patent Publication No. 2010-087282

### SUMMARY OF THE INVENTION

### TECHNICAL PROBLEM

The semiconductor elements described in Patent Documents 1 and 2 were simulated regarding the reflectance according to the description of Patent Documents 1 and 2.

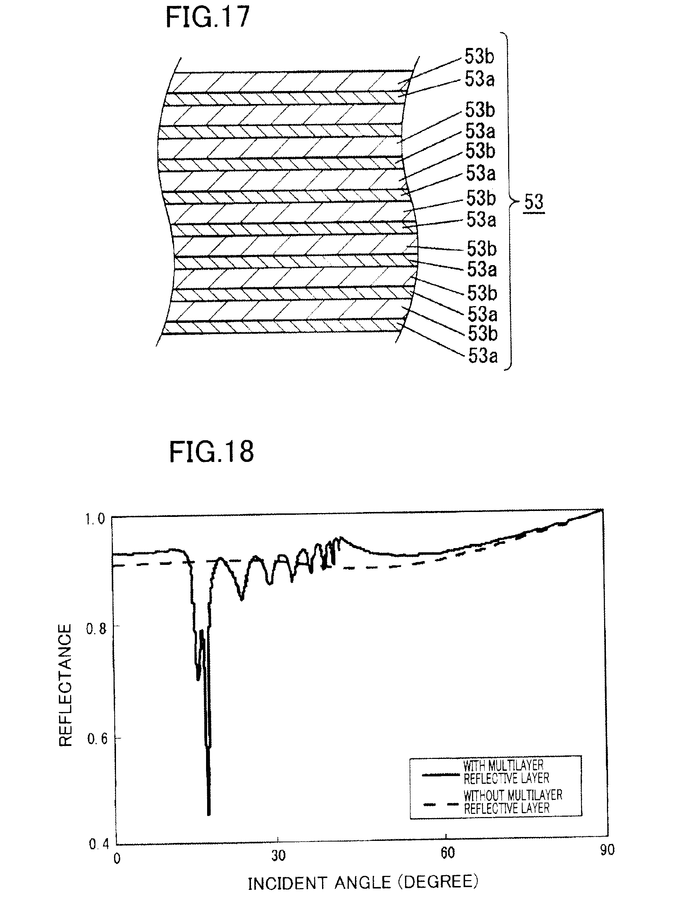

Patent Document 1 describes that in the case where dielectric films (low refractive index transparent layers) 53a forming a multilayer reflective film layer (multilayer reflective layer) 53 are comprised of SiO₂, and dielectric films (high refractive index transparent films) 53b forming the multilayer reflective film layer (multilayer reflective film) 53 are comprised of ZnO₂ as shown in FIG. 17. the thickness D of each dielectric film 53a and each dielectric film 53b of the multilayer reflective film layer 53 is 82 nm and 62 nm, respectively, as given by the relational expression "(thickness D x refractive index n)/(2m - 1) = λ/4 (where m = 1, 2, ..., and λ = 470 nm). Under these conditions, simulation was conducted regarding the reflectance of the multilayer reflective film layer (multilayer reflective layer) and the metal reflective film (metal reflective layer).

As shown in FIG. 18, the simulation result shows that the reflectance dropped significantly depending on the incident angle. In particular, the reflectance decreased by about 55% when light was incident from a direction shifted by 15° from the 0° direction that is perpendicular to the surface of the multilayer reflective film layer 53. The average reflectance was 92.8%.

Patent Document 2 describes that each low refractive index transparent film (low refractive index transparent layer) is formed by stacking a SiO₂ layer and a ZrO₂ layer, and "t1" and "t2" that satisfy the condition of (t1·λ/4n1 + t2·λ/4n2) ≥ (5/4)·λ are t1 = 31.1 nm and t2 = 159.1nm (where "t1" represents the thickness of the SiO₂ layer, "n1" represents the refractive index thereof, "t2" represents the thickness of the ZrO₂ layer, and "n2" represents the refractive index thereof). Under these conditions, simulation was conducted regarding the reflectance of the low refractive index transparent films (low refractive index transparent layer) and the reflective conductive film (metal reflective layer).

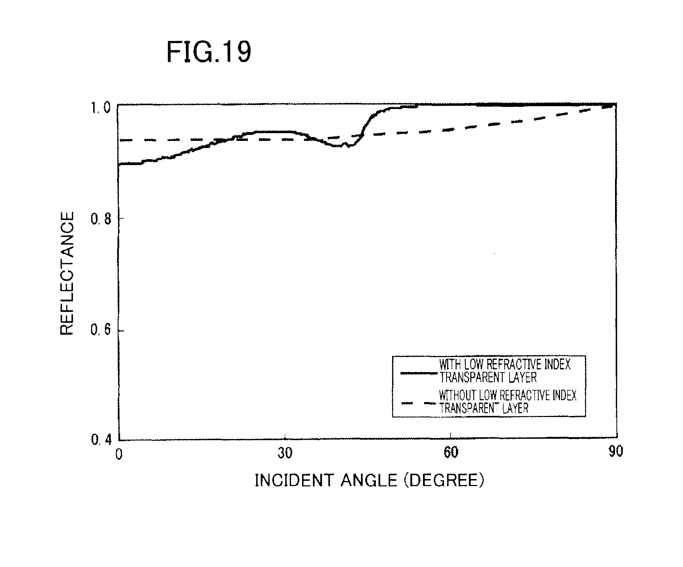

As shown in FIG. 19, the simulation result shows that the reflectance did not increase in the 0° direction that is perpendicular to the surface of each layer, and the average reflectance was 95.3%. Since the average reflectance was 94.3% without the low refractive index transparent films, providing the low refractive index transparent films improved the reflectance by about 1%.

As described above, Patent Document 1 does not satisfactorily effectively reflect all the light emitted from the light-emitting layer and incident at various angles toward the light extraction surface.

Patent Document 2 improved the reflectance by the low refractive index transparent films, but did not provide significant advantages.

It is an object of the present invention to provide a semiconductor light emitting element that achieves high light extraction efficiency by efficiently reflecting light emitted from a light-emitting layer and incident at various angles.

### SOLUTION TO THE PROBLEM

A semiconductor light emitting element of the present invention includes: a light-transmitting substrate; a semiconductor layer including an N-type semiconductor layer, a light-emitting layer, and a P-type semiconductor layer which are stacked on the substrate; a transparent conductive layer provided on the semiconductor layer; a multilayer reflective layer stacked on a reflective region of an upper surface of the transparent conductive layer which is divided into the reflective region as a region where light from the light-emitting layer is reflected and a conductive region as a region other than the reflective region; and a metal reflective layer provided so as to cover the conductive region and the multilayer reflective layer, wherein the multilayer reflective film is formed by alternately stacking at least one first refractive index transparent layer having a refractive index of n1 and at least one second refractive index transparent layer having a refractive index of n2 lower than n 1, and an outermost layer on the metal reflective layer side of the multilayer reflective film is the second refractive index transparent layer. As used herein, the term "light-transmitting" means the ability to transmit light from the light-emitting layer therethrough.

### ADVANTAGES OF THE INVENTION

According to the semiconductor light emitting element of the present invention, light emitted from the light-emitting layer and incident at various angles can be efficiently reflected by the interface between the metal reflective layer and the second refractive index transparent layer, whereby light extraction efficiency can be improved.

### BRIEF DESCRIPTION OF THE DRAWINGS

[FIG. 1] FIG. 1 is a diagram showing a semiconductor light emitting element according to a first embodiment of the present invention.
[FIG. 2] FIG. 2 is a diagram illustrating a conductive region and a reflective region of the semiconductor light emitting element shown in FIG. 1.
[FIG. 3] FIG. 3 is a diagram showing the configuration of a multilayer reflective layer of the semiconductor light emitting element shown in FIG. 1.
[FIG. 4] FIG. 4A is a diagram showing the refractive index of the multilayer reflective layer of the semiconductor light emitting element shown in FIG. 1, and FIG. 4B is a diagram showing the refractive index of a multilayer reflective layer of a semiconductor light emitting element of a comparative example.
[FIG. 5] FIG. 5 is a diagram showing conditions for simulating the semiconductor light emitting element according to the first embodiment.
[FIG. 6] FIG. 6 is a diagram showing the configuration of the multilayer reflective layer shown in FIG. 5.
[FIG. 7] FIG. 7 is a graph showing the result of the simulation conducted under the conditions shown in FIG. 5.
[FIG. 8] FIG. 8 is a diagram showing the configuration of a multilayer reflective layer of a semiconductor light emitting element according to a second embodiment.
[FIG. 9] FIG. 9 is a diagram showing conditions for simulating the semiconductor light emitting element according to the second embodiment.
[FIG. 10] FIG. 10 is a graph showing the result of the simulation conducted under the conditions shown in FIG. 9.
[FIG. 11] FIG. 11 is a diagram showing the configuration of a multilayer reflective layer of a semiconductor light emitting element according to a third embodiment.
[FIG. 12] FIG. 12 is a diagram showing conditions for simulating the semiconductor light emitting element according to the third embodiment.
[FIG. 13] FIG. 13 is a graph showing the result of the simulation conducted under the conditions shown in FIG. 12.
[FIG. 14] FIG. 14 is a diagram showing the configuration of a multilayer reflective layer of a semiconductor light emitting element according to a fourth embodiment.
[FIG. 15] FIG. 15 is a diagram showing conditions for simulating the semiconductor light emitting element according to the fourth embodiment.
[FIG. 16] FIG. 16 is a graph showing the result of the simulation conducted under the conditions shown in FIG. 15.
[FIG. 17] FIG. 17 is a diagram of a multilayer reflective layer of a semiconductor light emitting element described in Patent Document 1.
[FIG. 18] FIG. 18 is a graph showing the result of simulating the semiconductor light emitting element shown in FIG. 17.
[FIG. 19] FIG. 19 is a graph showing the result of simulating a semiconductor light emitting element described in Patent Document 2.

### DESCRIPTION OF EMBODIMENTS

A semiconductor light emitting element according to an embodiment includes: a light-transmitting substrate; a semiconductor layer including an N-type semiconductor layer, a light-emitting layer, and a P-type semiconductor layer which are stacked on the substrate; a transparent conductive layer provided on the semiconductor layer; a multilayer reflective layer stacked on a reflective region of an upper surface of the transparent conductive layer which is divided into the reflective region as a region where light from the light-emitting layer is reflected and a conductive region as a region other than the reflective region; and a metal reflective layer provided so as to cover the conductive region and the multilayer reflective layer, wherein the multilayer reflective layer is formed by alternately stacking at least one first refractive index transparent layer having a refractive index of n1 and at least one second refractive index transparent layer having a refractive index of n2 lower than n1, and an outermost layer on the metal reflective layer side of the multilayer reflective layer is the second refractive index transparent layer.

According to the above characteristics, since the outermost layer on the metal reflective layer side of the multilayer reflective layer is the second refractive index transparent layer having a lower refractive index than the first refractive index transparent layer, the difference in refractive index from the metal reflective layer can be made larger than that in the case where the outermost layer is the first refractive index transparent layer. This allows light to be efficiently reflected by the interface between the metal reflective layer and the second refractive index transparent layer, and thus can enhance light extraction efficiency.

In a preferred embodiment, the first refractive index transparent layer has a thickness of λ/4n1, and the second refractive index transparent layer has a thickness of λ/4n2 (where λ represents a wavelength of the light emitted from the light-emitting layer). With this configuration, reflectance can be increased, and internal stress of the first refractive index transparent layer and the second refractive index transparent layer can be reduced.

In a more preferred embodiment, a dielectric layer having a lower refractive index than the second refractive index transparent layer and having a thickness larger than λ/4 is provided between the multilayer refractive layer and the transparent conductive layer. With this configuration, the reflectance drops at a specific incident angle, but is increased in an incident angle region equal to or larger than a critical angle of the dielectric layer in a reflectance curve with respect to the incident angle. The average reflectance can thus further be increased, and the light extraction efficiency can be enhanced.

In another preferred embodiment, an outermost layer on the light-emitting layer side of the multilayer reflective layer is the first refractive index transparent layer. With this configuration, since the outermost layer on the metal reflective layer side of the multilayer reflective layer is the second refractive index transparent layer. Accordingly, if the first refractive index transparent layer and the second refractive index transparent layer are used as a pair, providing the first refractive index transparent layer as the outermost layer on the light-emitting layer side can reduce the number of layers of the multilayer reflective layer as compared to the case where the second refractive index transparent layer is provided as the outermost layer on the light-emitting layer side, if the number of pairs of the first refractive index transparent layer and the second refractive index transparent layer is the same. The internal stress of the multilayer reflective layer can further be reduced.

In still another preferred embodiment, an outermost layer on the light-emitting layer side of the multilayer reflective layer is the second refractive index transparent layer. With this configuration, the reflectance at the incident angle closer to 0° can be particularly increased, and the average reflectance can further be increased although the number of layers is larger than the case where the outermost layer on the light-emitting layer side is the first refractive index transparent layer.

In a further preferred embodiment, the second refractive index transparent layer is comprised of Al₂O₃, and the metal reflective layer is comprised of Ag. With this configuration, due to high adhesion of Al₂O₃ used as the second refractive index transparent layer, the second refractive index transparent layer comprised of Al₂O₃ is highly adhesive to Ag that is preferably used as the metal reflective layer in order to increase the reflectance. Moreover, this second refractive index transparent layer has high thermal conductivity, which is effective in dissipating heat generated by the light-emitting layer.

### (First Embodiment)

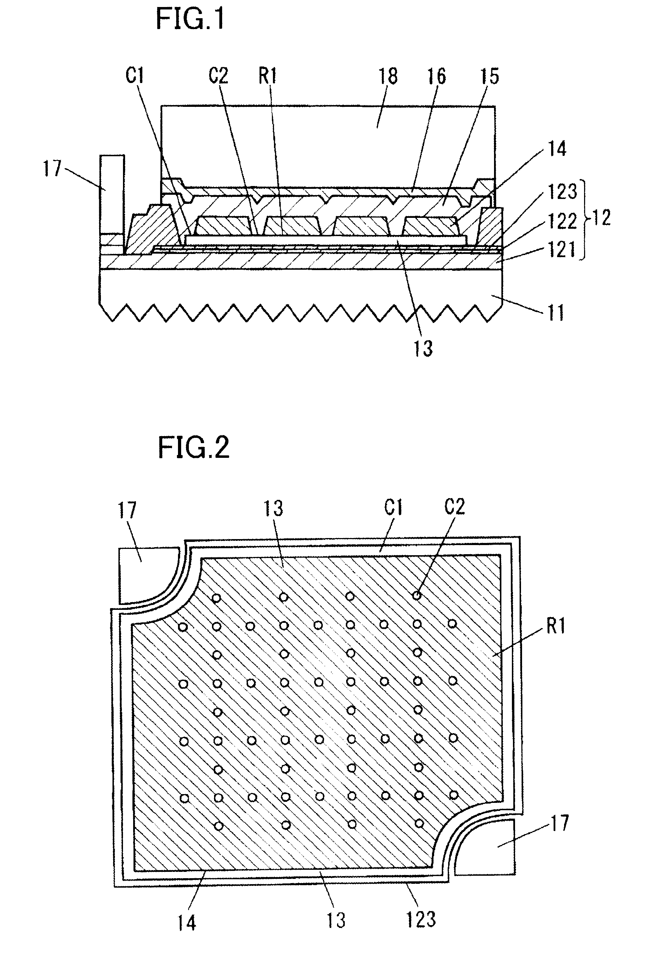

A semiconductor light emitting element according to a first embodiment will be described with reference to the accompanying drawings. The light emitting element shown in FIG. 1 is an LED chip to be flip-chip mounted on a mount substrate with bumps interposed therebetween.

As shown in FIG. 1, the semiconductor light emitting element includes: a semiconductor layer 12 stacked on a light-transmitting substrate 11; a transparent conductive layer 13 formed on the semiconductor layer 12; a multilayer reflective layer 14 stacked on the transparent conductive layer 13; a metal reflective layer 15 formed on the multilayer reflective layer 14; a barrier metal layer 16; an N-electrode 17 as a cathode; and a P-electrode 18 as an anode.

A substrate that allows light from a light-emitting layer 122 to transmit therethrough can be used as the light-transmitting substrate 11. For example, a sapphire substrate, a SiC substrate, a ZnO substrate, a GaN substrate, an AlN substrate, etc. can be used as the light-transmitting substrate 11. The light-transmitting substrate 11 may have an insulation property. However, using the light-transmitting substrate having N-type conductivity allows a current to flow more extensively, and allows the semiconductor light emitting element to be operated at a lower voltage.

The semiconductor layer 12 is a stack of an N-type semiconductor layer 121, the light-emitting layer 122, and a P-type semiconductor layer 123.

The N-type semiconductor layer 121 can be an N-type GaN layer. The N-type semiconductor layer 121 is not limited to a single layer structure, but may have a multilayer structure. For example, in the case where the light-transmitting substrate 11 is a sapphire substrate, the N-type semiconductor layer 121 may be a stack of an N-type AlGaN layer and an N-type GaN layer formed thereon with a buffer layer such as an AlN layer or an AlGaN layer being interposed between the light-transmitting substrate 11 and the N-type semiconductor layer 121.

The light-emitting layer 122 contains at least Ga and N, and can have a desired emission wavelength by additionally containing an appropriate amount of In as necessary. The light-emitting layer 122 may have a single layer structure, and may have a multiple quantum well structure in which, e.g., at least one pair of an InGaN layer and a GaN layer are alternately stacked. In the present embodiment, the composition of the InGaN layer is designed so that the light-emitting layer 122 has an emission peak wavelength of 450 nm. The light-emitting layer 122 may have a single quantum well structure or a single layer structure.

The P-type semiconductor layer 123 can be a P-type GaN layer. The P-type semiconductor layer 123 is not limited to a single layer structure, but may have a multilayer structure. In this case, for example, the P-type semiconductor layer 123 can be a multilayer film as a stack of a P-type AlGaN layer and a P-type GaN layer. In the case where the P-type semiconductor layer 123 is a P-type GaN layer or a multilayer film as a stack of a P-type AlGaN layer and a P-type GaN layer, the refractive index can be regarded as an average value obtained in view of the refractive index and the thickness of each layer.

The semiconductor layer 12 can be formed on the light-transmitting substrate 11 by an epitaxial growth technique such as an MOVPE method. The semiconductor layer 12 can also be formed by, e.g., a hydride vapor phase epitaxy method (HVPE method), a molecular beam epitaxy method (MBE method), etc.

The transparent conductive layer 13 can be comprised of a GZO film having a lower refractive index than the P-type semiconductor layer 123. For example, the transparent conductive layer 13 can be comprised of a ternary metal oxide selected from the group consisting of GZO (Ga-doped ZnO), AZO (Al-doped ZnO), and ITO. The transparent conductive layer 13 need only have a thickness of 10 nm or more. In the present embodiment, the transparent conductive layer 13 is designed to have a thickness of 100 nm. The transparent conductive layer 13 comprised of such a material can form an ohmic contact with the P-type semiconductor layer 123.

The multilayer reflective layer 14 is stacked on the transparent conductive layer 13. As shown in FIG. 2, the multilayer reflective layer 14 is provided in a region assigned as a reflective region R1 where light transmitted through the transparent conductive layer 13 is reflected, specifically in a region excluding as a conductive region for electrical connection between the transparent conductive layer 13 and the metal reflective layer 15 both a peripheral portion C1 of the transparent conductive layer 13 and a lattice portion C2 where circular areas are arranged in rows and columns.

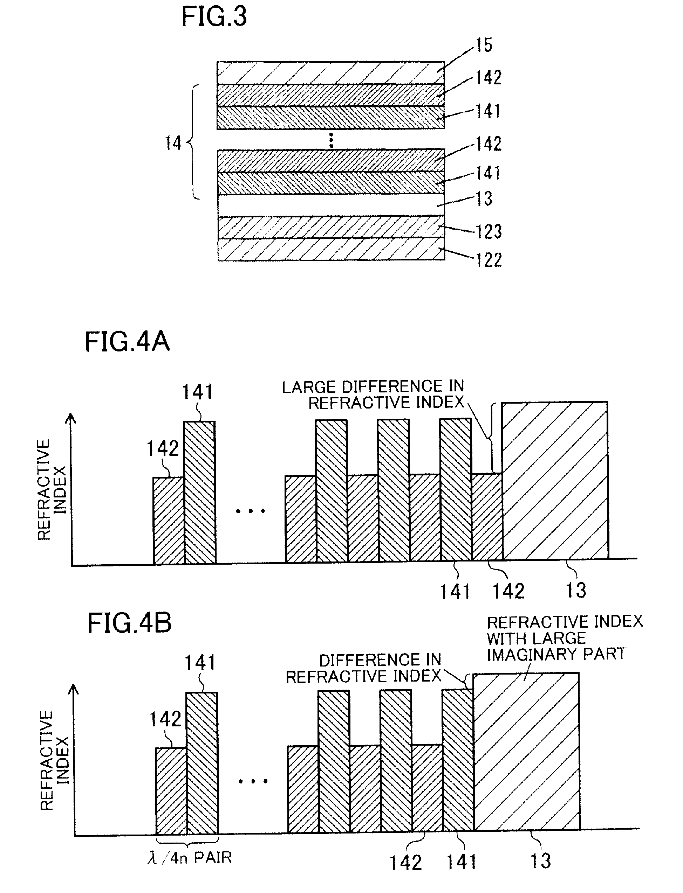

As shown in FIG. 3, the multilayer reflective layer 14 is formed by alternately and periodically stacking at least one high refractive index transparent layer (first refractive index transparent layer) 141 having a relatively high refractive index and at least one low refractive index transparent layer (second refractive index transparent layer) 142 having a lower refractive index than both the P-type semiconductor layer 123 and the high refractive index transparent layer 141 in this order in the reflective region R1. In the first embodiment, the outermost layer on the transparent conductive layer 13 side of the multilayer reflective layer 14 is the high refractive index transparent layer 141, and the outermost layer on the metal reflective layer 15 side of the multilayer reflective layer 14 is the low refractive index transparent layer 142. In the case where a single high refractive index transparent layer 141 and a single low refractive index transparent layer 142 are used as a pair, the advantages of the present invention can be obtained by stacking at least one pair of the high refractive index transparent layer 141 and the low refractive index transparent layer 142. However, it is desirable to stack three or more pairs, although it depends on the respective refractive indices of the high refractive index transparent layer 141 and the low refractive index transparent layer 142.

The high refractive index transparent layer 141 is formed with a thickness obtained by λ/4n1, and the low refractive index transparent layer 142 is formed with a thickness obtained by λ/4n2, where "λ" represents the emission wavelength of the light-emitting layer 122, "n1" represents the refractive index of the high refractive index transparent layer 141, and "n2" represents the refractive index of the low refractive index transparent layer 142. It is desirable that the thickness of each layer have a value obtained by the above expression, but a variation as small as a manufacturing margin of error or about several nanometers is substantially allowed.

The high refractive index transparent layer 141 can be comprised of Ta₂O₅, ZrO₂, Nb₂O₅, TiO₂, etc. Forming the high refractive index transparent layer 141 from such a material makes the refractive index thereof lower than the P-type semiconductor layer 123. The low refractive index transparent layer 142 can be comprised of Al₂O₃, SiO₂, SiN, etc. Forming the low refractive index transparent layer 142 from such a material makes the refractive index thereof lower than the P-type semiconductor layer 123. The high refractive index transparent layer 141 and the low refractive index transparent layer 142 thus have a lower refractive index than the P-type semiconductor layer 123. However, since GaN and AlGaN which form the P-type semiconductor layer 123 have a refractive index as high as about 2.5, there is almost no transparent layer that can be formed with a refractive index higher than the P-type semiconductor layer 123. If such a film can be formed, the refractive index of the high refractive index transparent layer 141 may be higher than that of the P-type semiconductor layer 123, or the refractive index of the low refractive index transparent layer 142 may be higher than that of the P-type semiconductor layer 123.

The larger the difference in refractive index between the high refractive index transparent layer 141 and the low refractive index transparent layer 142, the higher the degree of reflection of incident light is. The materials of the high refractive index transparent layer 141 and the low refractive index transparent layer 142 are selected so that the difference in refractive index therebetween becomes large.

As shown in FIG. 1, the metal reflective layer 15 is a metal layer that covers the conductive region for electrical connection with the transparent conductive layer 13 (the peripheral portion C1 and the lattice portion C2) and the low refractive index transparent layer 142 provided in the reflective region R1. In the first embodiment, the metal reflective layer 15 is an Ag layer having high reflectance. The metal reflective layer 15 comprised of the Ag layer can have a thickness of 100 nm. This thickness can be selected in the range of, e.g., about 50 nm to 400 nm. The metal reflective layer 15 may be an Al layer instead of the Ag layer. However, since the Ag layer has higher reflectance than the Al layer, the metal reflective layer 15 is preferably the Ag layer.

The barrier metal layer 16 is comprised of Ti, Mo, Pt, etc. Forming the barrier metal layer 16 between the metal reflection layer 15 and the P-electrode 18 can prevent metal diffusion therebetween, and thus prevent alloying. Forming the barrier metal layer 16 so as to cover the metal reflective layer 15 better suppresses migration of the metal reflective layer 15. The thickness of the barrier metal layer 16 is desirably 10 nm to 200 nm. The barrier metal layer 16 having a thickness of 10 nm or more can provide a sufficient barrier property, and the barrier metal layer 16 having a thickness of 200 nm or less requires a small amount of raw material to form the barrier metal layer 16, and requires only a short time to perform the step of forming the barrier metal layer 16. Preferably, the barrier metal layer 16 has a thickness of about 100 nm. The barrier metal layer 16 is not limited to Ti, Mo, and Pt, and may be comprised of a mixture thereof or any other materials. A high melting point material whose resistance value is not so high is suitable for the barrier metal layer 16.

The N-electrode 17 is a cathode electrode provided over a region of the N-type semiconductor layer 121 where the P-type semiconductor layer 123, the light-emitting layer 122, and a part of the N-type semiconductor layer 121 have been etched away. The N-electrode 17 is provided at opposing corners of the rectangular light-transmitting substrate 11. The position and shape of the N-electrode 17 are not limited to those shown in FIG. 2. For example, the N-electrode 17 may be provided at all of the four corners, or may have a shape other than a quarter of a circle. The N-electrode 17 is formed by stacking an Al layer, a Ti layer, and an Au layer. The Al layer of the N-electrode 17 which is stacked over the N-type semiconductor layer 121 functions as an ohmic contact layer with the N-type semiconductor layer 121. The material of the ohmic contact layer can be, e.g., Ti, V, Al, an alloy containing any one of these metals, etc. The Au layer stacked on the Ti layer functions as an N-pad layer.

The P-electrode 18 is an anode electrode stacked on the barrier metal layer 16. The P-electrode 18 is provided in the remaining area excluding the region where the N-electrode 17 is provided. The P-electrode 18 is formed by stacking a Ti layer formed on the barrier metal layer 16 and an Au layer. The uppermost Au layer functions as a P-pad layer. The P-electrode 18 is mounted on a mount substrate with bumps interposed therebetween so that the P-electrode 18 is electrically connected to the mount substrate. The bumps are arranged in a matrix at regular intervals.

According to the semiconductor light emitting element thus configured, the metal reflective layer 15 is formed as a non-light-transmitting metal layer, and the outermost low refractive index transparent layer 142 contacts the metal reflective layer 15 (see FIG. 4A). This can increase the difference in refractive index at the interface as compared to a comparative example in which the high refractive index transparent layer contacts the metal reflective layer 15 (see FIG. 4B). Since light transmitted through the multilayer reflective layer 14 to the metal reflective layer 15 can be efficiently reflected by the interface therebetween, the reflected light can be emitted from the light-transmitting substrate 11. The semiconductor light emitting element according to the first embodiment can thus enhance light extraction efficiency.

In the case where the high refractive index transparent layer 141 and the low refractive index transparent layer 142 are used as a pair, providing the high refractive index transparent layer 141 as the outermost layer on the light-emitting layer 122 side can reduce the number of layers of the multilayer reflective layer 14 as compared to the case where the low refractive index transparent layer 142 is provided as the outermost layer on the light-emitting layer 122 side, if the number of pairs of the high refractive index transparent layer 141 and the low refractive index transparent layer 142 is the same. Internal stress of the multilayer reflective layer can thus be reduced.

### (Simulation of Semiconductor Light Emitting Element of First Embodiment)

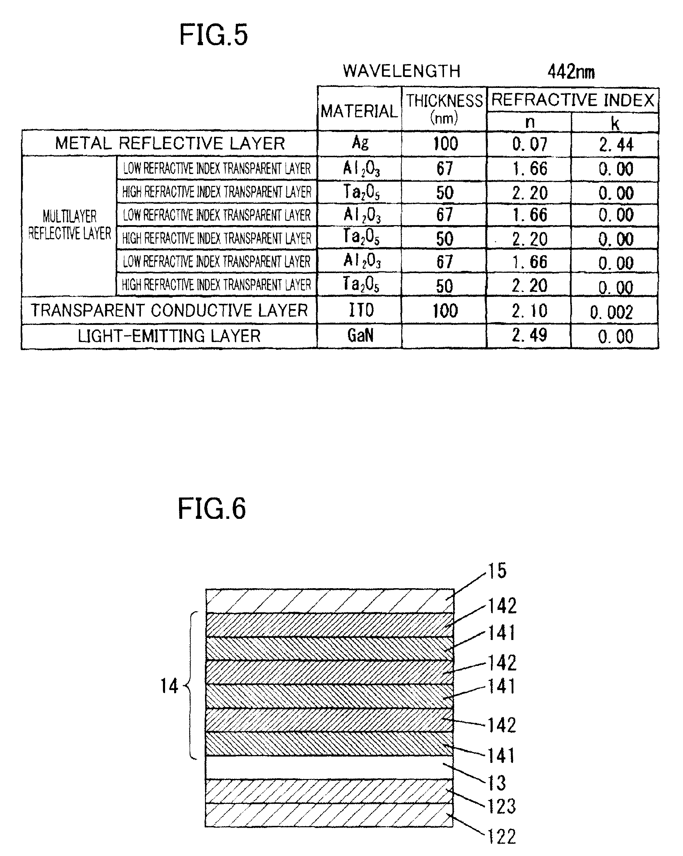

The semiconductor light emitting element according to the first embodiment was simulated under the conditions shown in FIG. 5.

In this simulation, the light-emitting layer 122 was a layer emitting blue light with a peak emission wavelength of 442 nm, and the light-emitting layer 122, the transparent conductive layer 13, the multilayer reflective layer 14 (the high refractive index transparent layer 141 and the low refractive index transparent layer 142), and the metal reflective layer 15 had refractive indices as shown in FIG. 5. The transparent conductive layer 13 comprised of an ITO layer had a thickness of 100 nm, and the metal reflective layer 15 comprised of an Ag layer had a thickness of 100 nm. The multilayer reflective layer 14 was formed by three pairs of the high refractive index transparent layer 141 and the low refractive index transparent layer 142 as shown in FIG. 6. Since a Ta₂O₅ layer having a refractive index of 2.20 was used as the high refractive index transparent layer 141, the high refractive index transparent layer 141 of the multilayer reflective layer 14 had a thickness of 442 nm/(4 x 2.20) = 50.23 rounded off to the nearest whole number, namely 50 nm. Since a Al₂O₃ layer having a refractive index of 1.66 was used as the low refractive index transparent layer 142, the low refractive index transparent layer 142 had a thickness of 442 nm/(4 x 1.66) = 66.57 rounded off to the nearest whole number, namely 67 nm.

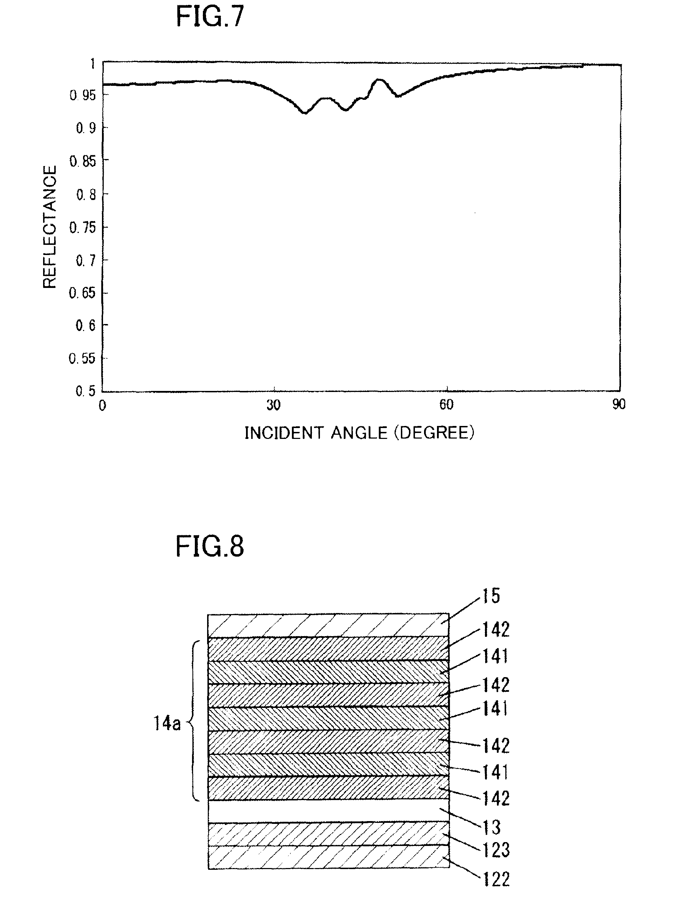

Under the above conditions, simulation was conducted regarding the incident angle in the range from the 0° direction perpendicular to the surface of the multilayer reflective layer 14 to the 90° direction parallel to the surface of the multilayer reflective layer 14. As a result, the average reflectance was 97.1 % (FIG. 7 shows a graph of the simulation result).

The reason for this is as follows. The metal reflective layer 15 is comprised of Ag, and the real part of the complex refractive index is 0.07, but the imaginary part thereof is as high as 2.24. Accordingly, the difference in refractive index is large between the metal reflective layer 15 and the low refractive index transparent layer 142 having a refractive index of 1.66.

For example, in the semiconductor light emitting element described in Patent Document 1, the dielectric film 53a of the multilayer reflective film layer 53 shown in FIG. 17 is comprised of SiO₂ (refractive index: 1.43) and the dielectric film 53b thereof is comprised of ZrO₂ (refractive index: 1.89). Accordingly, the dielectric film 53a comprised of the SiO₂ layer corresponds to the low refractive index transparent layer 142, and the dielectric film 53b comprised of the ZrO₂ layer corresponds to the high refractive index transparent layer 141. The combination of the metal reflective film and the dielectric film 53b in the semiconductor light emitting element described in Patent Document 1 therefore cannot ensure a large difference in refractive index.

Similarly, in the semiconductor light emitting element described in Patent Document 2, the low refractive index transparent film is comprised of SiO₂ (refractive index: 1.43) and ZrO₂ (refractive index: 1.89), and an adhesive conductive layer comprised of a metal layer is formed between the low refractive index transparent film and the reflective conductive film. Accordingly, the SiO₂ layer corresponds to the low refractive index transparent layer 142, and the ZrO₂ layer corresponds to the high refractive index transparent layer 141. The combination of the reflective conductive film and the low refractive index transparent film in the semiconductor light emitting element described in Patent Document 2 therefore cannot ensure a large difference in refractive index.

As can be seen from the fact that the average reflectance of the semiconductor light emitting element according to the first embodiment was able to be improved by 4.1 % over the semiconductor light emitting element described in Patent Document 1 and was able to be improved by 1.8% over the semiconductor light emitting element described in Patent Document 2, the semiconductor light emitting element according to the first embodiment can provide higher light extraction efficiency than the semiconductor light emitting elements described in Patent Documents 1 and 2.

### (Second Embodiment)

A semiconductor light emitting element according to a second embodiment of the present invention will be described with reference to the accompanying drawings. In FIG. 8, elements having the same configurations as those of FIG. 6 are denoted by the same reference characters, and description thereof will be omitted.

As shown in FIG. 8, the semiconductor light emitting element according to the second embodiment is characterized in that the outermost layer on the light-emitting layer side of a multilayer reflective layer 14a is the low refractive index transparent layer 142.

Such a multilayer refractive film 14a can increase delamination resistance of the low refractive index transparent layer 142 from the transparent conductive layer 13 because the transparent conductive layer 13 comprised of an ITO layer contacts the low refractive index transparent layer 142 comprised of an Al₂O₃ layer having high adhesion to the ITO layer.

### (Simulation of Semiconductor Light Emitting Element of Second Embodiment)

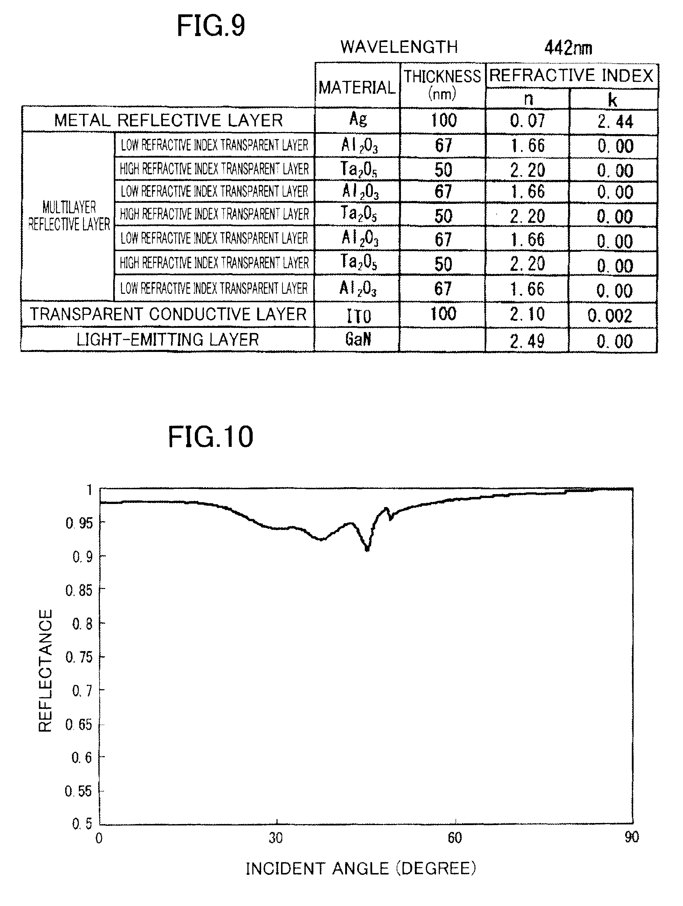

The semiconductor light emitting element according to the second embodiment was simulated under the conditions shown in FIG. 9. The conditions shown in FIG. 9 are the same as those in the first embodiment shown in FIG. 5 except that an additional low refractive index transparent layer 142 was provided on the transparent conductive layer 13 side.

Under the above conditions, simulation was conducted regarding the incident angle to the multilayer reflective layer 14a. In this case, the outermost layer on the light-emitting layer 122 side of the multilayer reflective layer 14a is the low refractive index transparent layer 142. Accordingly, if the number of pairs of the high refractive index transparent layer 141 and the low refractive index transparent layer 142 is the same, the number of layers is increased but the reflectance at the incident angle close to 0° can be particularly increased as compared to the case where the outermost layer on the light-emitting layer 122 side is the high refractive index transparent layer 141. The average reflectance was 97.4% (FIG. 10 shows a graph of the simulation result). The result shows that the average reflectance was improved over the semiconductor light emitting element according to the first embodiment.

### (Third Embodiment)

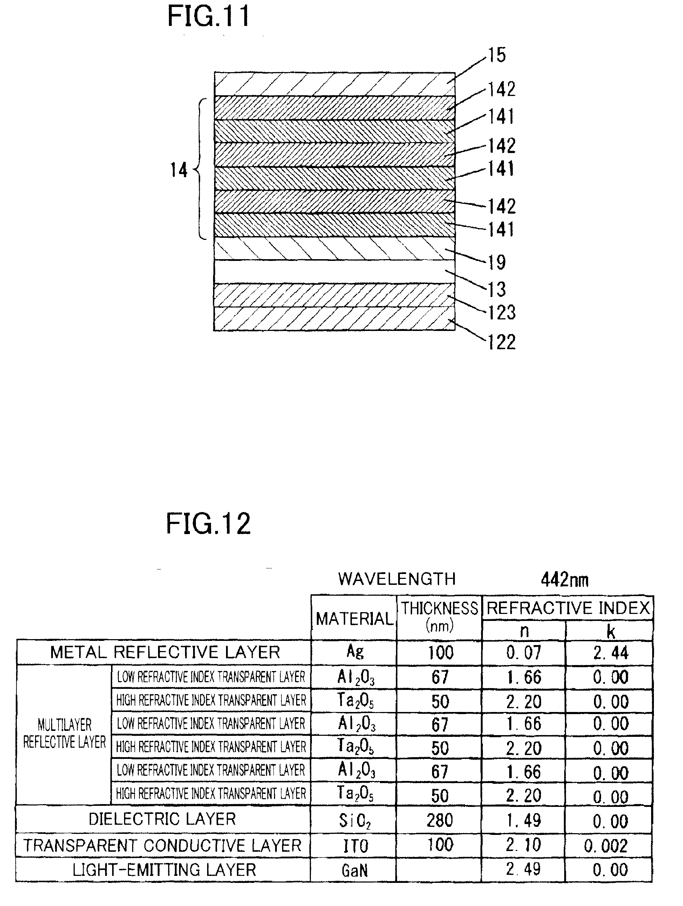

A semiconductor light emitting element according to a third embodiment of the present invention will be described with reference to the accompanying drawings. In FIG. 11, elements having the same configurations as those of FIG. 6 are denoted by the same reference characters, and description thereof will be omitted.

As shown in FIG. 11, the semiconductor light emitting element according to the third embodiment is characterized by including a dielectric layer 19 between the multilayer reflective layer 14 and the transparent conductive layer 13.

This dielectric layer 19 can be comprised of, e.g., SiO₂ etc. The dielectric layer 19 desirably has a thickness that is larger than a quarter of the emission wavelength of the light-emitting layer 122.

Providing such a dielectric layer 19 creates a region where the reflectance drops at the incident angle of 35 to 40°, but can increase the reflectance on average due to the effect of total reflection of the dielectric layer 19 at the incident angle of 40° or more.

### (Simulation of Semiconductor Light Emitting Element of Third Embodiment)

The semiconductor light emitting element according to the third embodiment was simulated under the conditions shown in FIG. 12. The conditions shown in FIG. 12 are the same as those of the first embodiment shown in FIG. 5 except that the dielectric layer 19 is added on the transparent conductive layer 13 side.

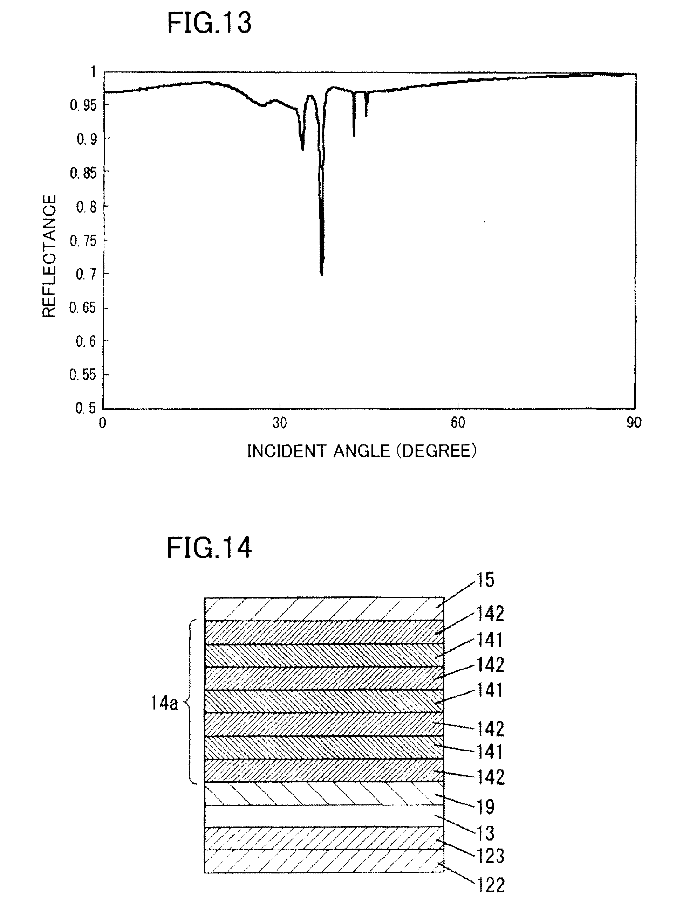

Under the above conditions, simulation was conducted regarding the incident angle to the multilayer reflective layer 14. The average reflectance was 97.6% (FIG. 13 shows a graph of the simulation result). The result shows that the average reflectance was improved over the semiconductor light emitting element according to the second embodiment.

### (Fourth Embodiment)

A semiconductor light emitting element according to a fourth embodiment of the present invention will be described with reference to the accompanying drawings. In FIG. 14, elements having the same configurations as those of FIG. 11 are denoted by the same reference characters, and description thereof will be omitted.

The semiconductor light emitting element according to the fourth embodiment shown in FIG. 14 is characterized by including the multilayer reflective layer 14a of the second embodiment and the dielectric layer 19 of the third embodiment.

### (Simulation of Semiconductor Light Emitting Element of Fourth Embodiment)

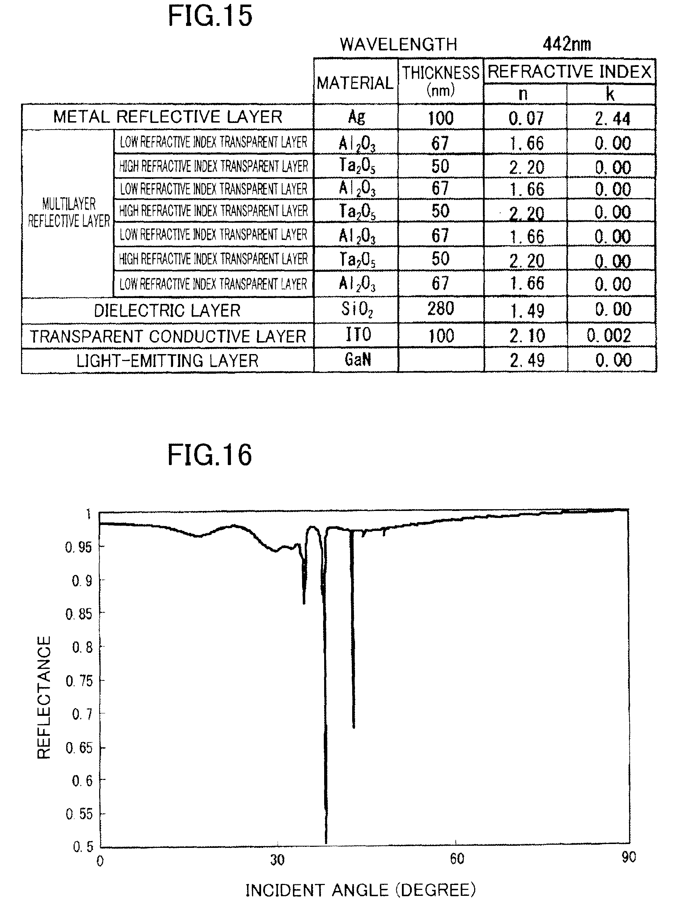

The semiconductor light emitting element according to the fourth embodiment was simulated under the conditions shown in FIG. 15. The conditions shown in FIG. 15 are the same as those shown in FIG. 5 except that the low refractive index transparent layer 142 is added on the transparent conductive layer 13 side and the dielectric layer 19 is added on the transparent conductive layer 13 side.

Under the above conditions, simulation was conducted regarding the incident angle to the multilayer reflective layer 14. Although the reflectance drops sharply at the incident angle close to 40°, but the average reflectance was 97.7% (FIG. 16 shows a graph of the simulation result). The result shows that the average reflectance was improved over the semiconductor light emitting element according to the third embodiment.

### INDUSTRIAL APPLICABILITY

The present invention can improve light extraction efficiency by efficiently reflecting light emitted from a light-emitting layer and incident at various angles. Accordingly, the present invention is preferable for manufacturing methods of a light-emitting element that includes a semiconductor layer including a light-emitting layer and stacked on a substrate, and a metal reflective layer reflecting light from the light-emitting layer toward the substrate.

### DESCRIPTION OF REFERENCE CHARACTERS

- 11: Light-Transmitting Substrate
- 12: Semiconductor Layer
- 13: Transparent Conductive Layer
- 14, 14a: Multilayer Reflective Layer
- l5: Metal Reflective Layer
- 16: Barrier Metal Layer
- 17: N-Electrode
- 18: P-Electrode
- 19: Dielectric Layer
- 121: N-Type Semiconductor Layer
- 122: Light-Emitting Layer
- 123: P-Type Semiconductor Layer
- 141: High Refractive Index Transparent Layer (First Refractive Index Transparent Layer)
- 142: Low Refractive Index Transparent Layer (Second Refractive Index Transparent Layer)
- C1: Peripheral Portion
- C2: Lattice Portion
- R1: Reflective Region

## Claims

1. A semiconductor light emitting element, comprising:
a light-transmitting substrate;
a semiconductor layer including an N-type semiconductor layer, a light-emitting layer, and a P-type semiconductor layer which are stacked on the substrate;
a transparent conductive layer provided on the semiconductor layer;
a multilayer reflective layer stacked on a reflective region of an upper surface of the transparent conductive layer which is divided into the reflective region as a region where light from the light-emitting layer is reflected and a conductive region as a region other than the reflective region; and
a metal reflective layer provided so as to cover the conductive region and the multilayer reflective layer, wherein
the multilayer reflective layer is formed by alternately stacking at least one first refractive index transparent layer having a refractive index of n1 and at least one second refractive index transparent layer having a refractive index of n2 lower than n1, and
an outermost layer on the metal reflective layer side of the multilayer reflective layer is the second refractive index transparent layer.

2. The semiconductor light emitting element of claim 1, wherein
the first refractive index transparent layer has a thickness of λ/4n1, and
the second refractive index transparent layer has a thickness of λ/4n2 (where λ represents a wavelength of the light emitted from the light-emitting layer).

3. The semiconductor light emitting element of claim 2, wherein
a dielectric layer having a lower refractive index than the second refractive index transparent layer and having a thickness larger than λ/4 is provided between the multilayer refractive layer and the transparent conductive layer.

4. The semiconductor light emitting element of any one of claims 1 to 3,
wherein
an outermost layer on the light-emitting layer side of the multilayer reflective layer is the first refractive index transparent layer.

5. The semiconductor light emitting element of any one of claims 1 to 3,
wherein
an outermost layer on the light-emitting layer side of the multilayer reflective layer is the second refractive index transparent layer.

6. The semiconductor light emitting element of any one of claims 1 to 5,
wherein
the P-type semiconductor layer has a refractive index higher than n2.

7. The semiconductor light emitting element of any one of claims 1 to 6,
wherein
the second refractive index transparent layer is comprised of Al₂O₃, and
the metal reflective layer is comprised of Ag.
